# EUROPEAN PATENT APPLICATION

(11) **EP 1 349 205 A1**
(43) Date of publication of application: **01.10.2003**
(21) Application number: 02007412.6
(22) Date of filing: 28.03.2002
(51) Int. Cl.: H01L 21/336, H01L 29/788

(54) **Structure of a low-voltage channel write/erase flash memory cell and fabricating method thereof**

(71) Applicant: eMemory Technology Inc., Hsinchu, Taiwan, R.O.C. (TW)
(72) Inventor: Hsu, Ching-Hsiang, Hsin-Chu City (TW); Yang, Ching-Sung, Chang-Hua, Hsien (TW)
(74) Representative: Grünecker, Kinkeldey, Stockmair & Schwanhäusser Anwaltssozietät

(57) **Abstract**

The present invention relates to a structure of a low-voltage channel write/erase flash memory cell and a fabricating method thereof, which structure comprises an N-substrate (20), a deep P-well (22) formed on the substrate (20), and an N-well (24) formed on the deep P-well (22). A deep p-type region (27) and a shallow p-type region (26) are ion-implanted in the N-well (24). The deep p-type region (27) is connected to the shallow p-type region (26). An n-type region (25) is ion-implanted in the deep p-type region (27) to be electrically shorted with the deep p-type region (27) and be used as a drain. Another n-type region (28) is also ion-implanted at one side of the shallow p-type region (26) to be used as a source. The present invention can apply the same voltage to the deep P-well (22) and the N-well (24) on the N-substrate (20) by adding in a triple well architecture so that the leakage current capably generated can be reduced to minimum, thereby effectively reducing end voltages when performing the operation of erasing, simplifying the design complexity of a charge pump circuit required by the whole structure, and enhancing the operating efficiency.

## Description

The present invention relates to a low-voltage channel write/erase flash memory cell and a fabricating method thereof according to the pre-characterizing clause of claim 1.

Flash memories have been widely used in electronic products such as portable computers or communication apparatuses because of their non-volatile functions of electrically writing and erasing. The channel Fowler-Nordheim effect is generally exploited to operate the flash memory cell structure. Because the array structure thereof becomes denser and denser, the operation of each memory cell begins to influence one another. Therefore, the array density of the memory cell structure designed by using this effect has a certain limit.

The source of the prior art flash memory cell needs not to be at the opposite side of the drain thereof, i.e., it is a separate source. Each drain corresponds to a well. Therefore, when the density increases, the drawback of penetrating the source and the drain will not arise. Therefore, the integration can be increased. However, when performing the operation of erasing, if a lower end voltage is to be used to reduce the burden of a charge pump circuit, a positive voltage originally applied to a word line and a source line grounding voltage will be respectively changed to a small positive voltage applied to the word line and a negative voltage applied to the source line. The negative voltage of the source line applied to the N-well will generate a forward bias across a p-n junction between the N-well and the grounded p-type substrate, thereby indirectly resulting in a leakage current I_{L} so as to fail the action of erasing.

This in mind, the present invention aims at providing a corresponding low-voltage channel write/erase flash memory cell and a fabricating method thereof so as to solve the above-mentioned problem.

This is achieved by a low-voltage channel write/erase flash memory cell and a fabricating method thereof according to claim 1. The dependent claims pertain to corresponding further developments and improvements.

As will be seen more clearly from the detailed description following below, the present invention can apply the same voltage to a deep P-well and an N-well on an N-substrate by adding in a triple well architecture so that the leakage current capably generated can be reduced to minimum, thereby effectively reducing end voltages when performing the operation of erasing, simplifying the design complexity of a charge pump circuit required by the whole structure, and enhancing the operating efficiency.

In the following, the invention is further illustrated by way of example, taking reference to the accompanying drawings. Thereof
Fig. 1 is a cross-sectional view of the structure of a prior art channel write/erase flash memory cell,
Figs. 2A to 2L are cross-sectional views showing the process flow of a flash memory cell according to a preferred embodiment of the present invention, and
Fig 3 is a cross-sectional view showing the operation of erasing of a flash memory cell according to the preferred embodiment of the present invention.

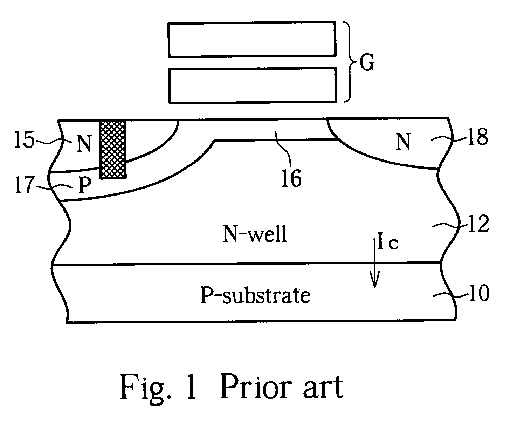

The prior art nonvolatile semiconductor memory device is disclosed in U.S. Pat. No. 6,091,644. Fig. 1 is a cross-sectional view of the structure of a prior art channel write/erase flash memory cell. As shown in the figure, an N-well 12 is formed on a p-type substrate 10. An n-type region 15 is ion-implanted into the N-well 12 to be used as a drain. A p-type region 16 is also implanted into the N-well 12. Another p-type region 17 is ion-implanted below the n-type region 15. Because the implanted depth of the p-type region 17 is much larger than that of the p-type region 16, it can be used as a P-well. The p-type region 17 is connected to the p-type region 16. Moreover, an n-type region 18 is also ion-implanted at anther end of the p-type region 16 to be used as a source. A stacked gate G is disposed above the p-type region 16.

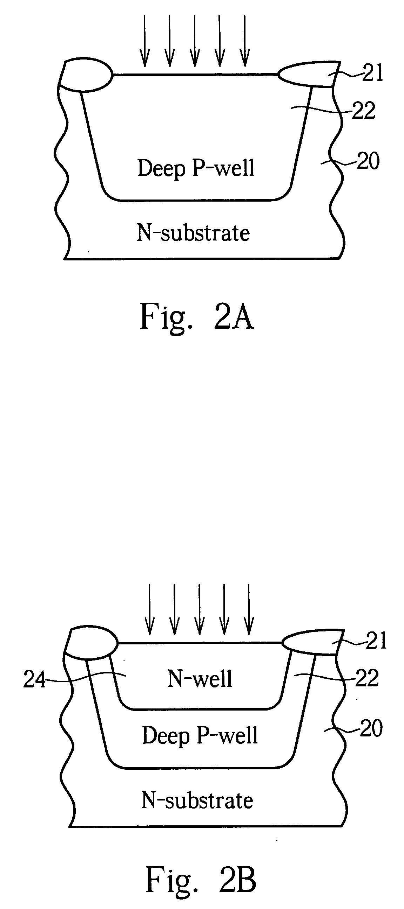

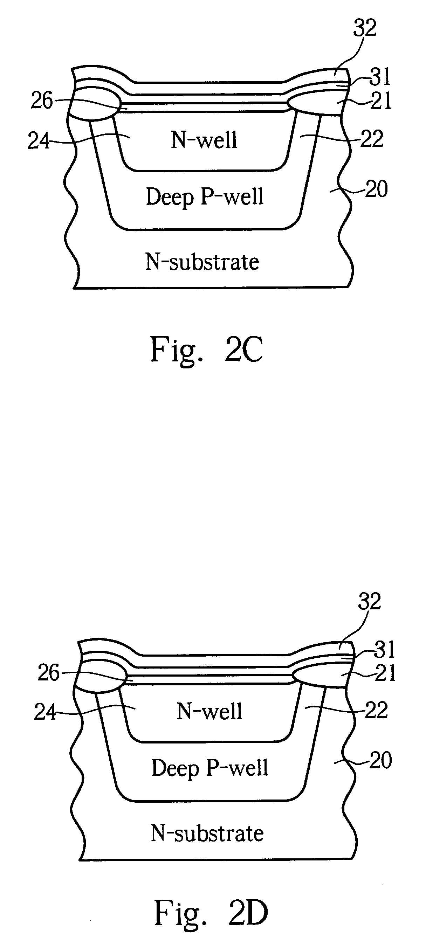

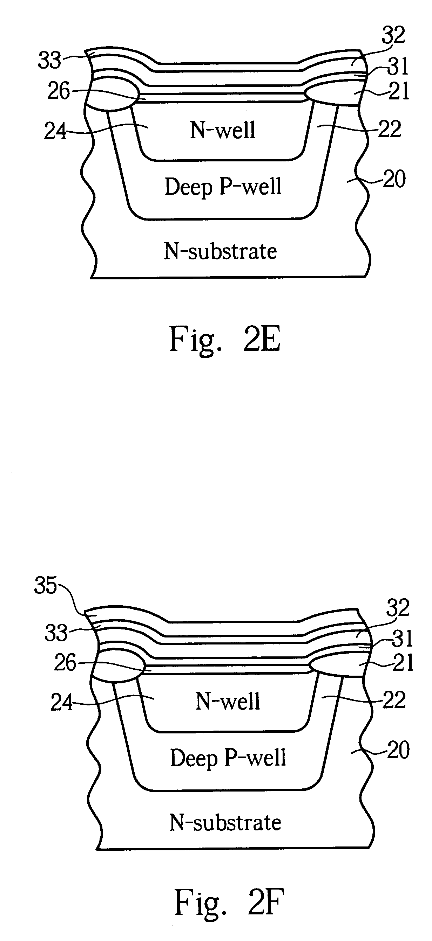

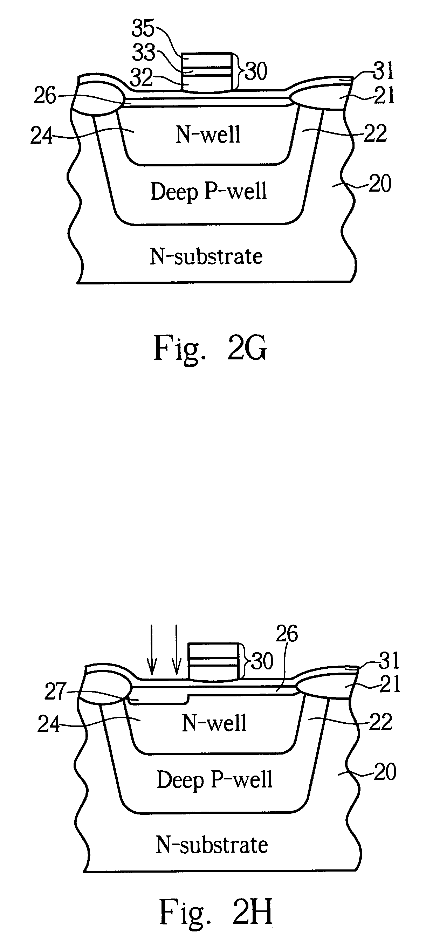

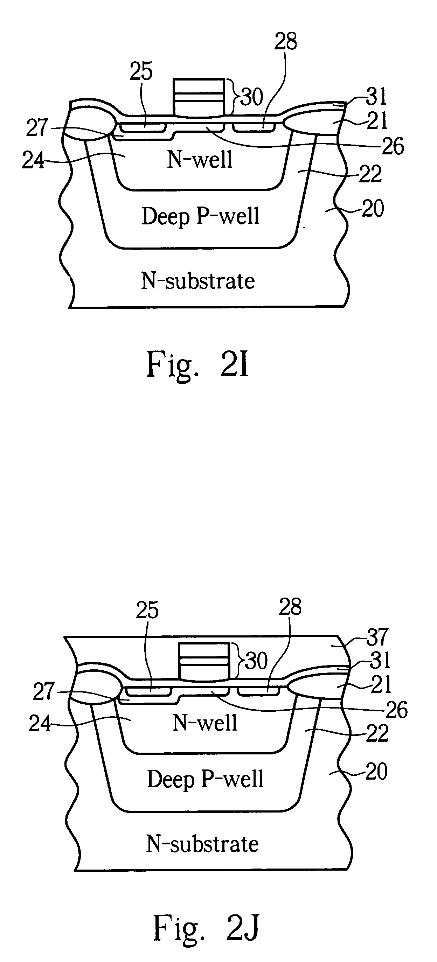

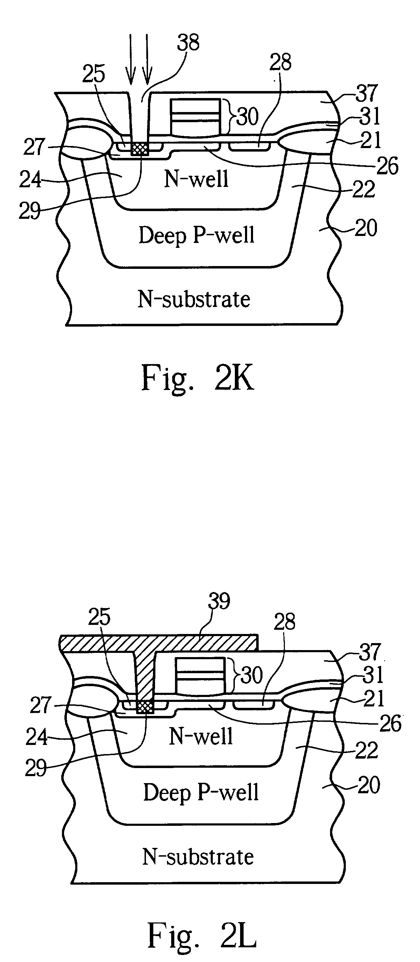

Figs. 2A to 2L are cross-sectional views showing the process flow of a flash memory cell according to a preferred embodiment of the present invention. The fabricating method of the present invention comprises mainly the following steps:
Step A: A semiconductor N-substrate 20 is provided; a plurality of field oxides (FOX) 21 are formed at specific regions in the substrate 20 using photolithography and oxidation techniques; a deep P-well 22 is ion-implanted in the substrate 20 between the field oxides 22, as shown in Fig. 2A;
Step B: An N-well 24 is formed in the deep P-well 22 of the substrate 20 using ion-implantation technique, as shown in Fig. 2B;
Step C: A shallow p-type region 26 is formed on the surface of the N-well 24 using ion-implantation technique; a tunnel oxide 31 is grown on the surface of the N-well; a first poly-Si layer 32 is then deposited and stacked on the tunnel oxide 31, as shown in Fig. 2C;
Step D: The patterns of the tunnel oxide 31 and the first poly-Si layer 32 are defined using photolithography and etching techniques, as shown in Fig. 2D;
Step E: An ONO film 33 is deposited on the etched tunnel oxide 31 and the etched first poly-Si layer 32; The ONO film 33 is then etched, as shown in Fig. 2E;
Step F: A second poly-Si layer 35 is deposited and stacked on the surface of the ONO film 33, as shown in Fig. 2F;
Step G: The second poly-Si layer 35 on the N-well 24, the ONO film 33, and the first poly-Si layer 32 are etched using anisotropic dry etching technique until the tunnel oxide 31 is exposed, thereby forming a rectangular stacked layer 30; only part of the tunnel oxide 31 straddling between two field oxides 21 is reserved; a thicker tunneling oxide is formed at the edge of the rectangular stacked layer 30 by means of oxidation to form a smiling effect oxide 312, as shown in Fig. 2G;
Step H: A deep p-type region 27 is formed in the N-well 24 at the left side of the rectangular stacked layer 30, and a shallow p-type region 26 is formed in the N-well 24 below the rectangular stacked layer 30 using ion-implantation technique; the implanted depth of the deep p-type region 27 is larger than that of the shallow p-type region 26, as shown in Fig. 2H;
Step I: Two n-type regions 25 and 28 are formed in the N-well 24 at two sides of the rectangular stacked layer 30 using ion-implantation technique; the n-type region 25 at the left side of the rectangular stacked layer 30 is implanted in the deep p-type region 27, as shown in Fig. 2I;
Step J: A third poly-Si layer 37 is deposited to cover the rectangular stacked layer 30 and the exposed tunnel oxide 31 at two sides thereof, as shown in Fig. 2J;
Step K: The insulating layer 37 at the left side of the rectangular stacked layer 30 is etched to form a contact hole 38 so as to expose the part with the deep p-type region 27 and the n-type region 25 implanted therein; the deep p-type region 27 and the n-type region 25 are electrically shorted via a metal 29, as shown in Fig. 2K; and
Step L: Connection of metals is performed; i.e., a metal contact 39 is connected to the deep p-type region 27 and the n-type region 25 via the etched contact hole 38 of the insulating layer 37, as shown in Fig. 2L.

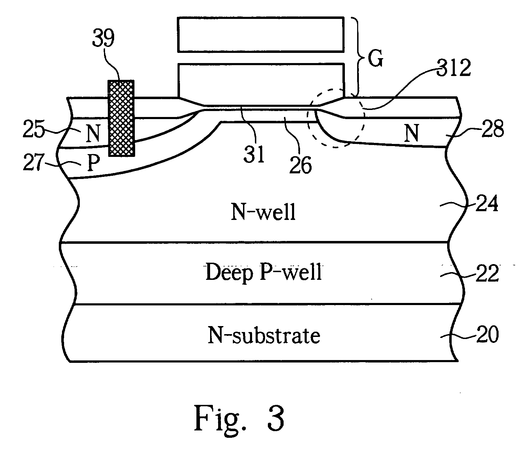

Fig. 3 is a cross-sectional view showing the operation of erasing of a flash memory cell according to the preferred embodiment of the present invention, wherein a deep P-well 22 is formed on an N-substrate 20, and an N-well 24 is formed on the P-well 22. A deep p-type region 27 and a shallow p-type region 26 are ion-implanted in the N-well 24. The deep p-type region 27 is connected to one end of the shallow p-type region 26. An n-type region 25 is further ion-implanted in the deep p-type region to electrically short with the deep p-type region 27 and be used as a drain. Another n-type region 28 is also implanted at one side of the shallow p-type region 26 to be used a source. Furthermore, the implanted depth of the deep p-type region 27 is larger than that of the shallow p-type region, i.e., the deep p-type region can also be used as a P-well. A tunnel oxide 31 is disposed above the N-well 24 to form a smiling effect junction with a stacked control gate G by oxidation. Thereby, program disturb generated when performing the operation of programming can be reduced through the structure change of the tunnel oxide 31. Additionally, the stacked control gate G comprises a control gate and a float gate.

Because the present invention is operated at low voltages, the same voltage can be applied to the deep P-well 22 and the N-well 24 on the N-substrate 20, such as a source line voltage V_{SL} and a deep P-well voltage V_{deep P-well}, to let the leakage current possibly generated be reduced to minimum. As shown in Table 1, when performing the operation of erasing, the source line voltage V_{SL} is set to -8V, the deep P-well voltage V_{deep} _{P-well} is set to -8V, and a word line voltage V_{WL} is set to 10V. Thereby, the source line voltage V_{SL} and the deep P-well voltage V_{deep P-well} will balance each other so that forward bias will not be formed across a p-n junction between the deep P-well 22 and the N-substrate 20, hence reducing the leakage current.

**Table 1**

| | Bit line voltage V_{BL} | | Word line voltage V_{WL} | | Source line voltage V_{SL} | Deep P-well voltage V_{deep-P-well} |
|---|---|---|---|---|---|---|
| | Selected | Not selected | Selected | Not selected | | |
| Program | 6V | 0V | -10V | Floating | Floating | 0V |
| Erase | Floating | Floating | 10V | Floating | -8V | -8V |
| Read | 0V | Floating | 4V | Floating | 1V | 0V |

## Claims

1. A method of forming a low-voltage channel write/erase flash memory cell comprising steps of:
ion-implanting a shallow p-type region (26) on a surface of an N-well (24);
growing a tunnel oxide (31) on said shallow p-type region (26) and depositing a poly-Si layer (32);
etching said tunnel oxide (31) and said poly-Si layer (32);
etching out an ONO film (33) on said etched tunnel oxide (31) and said etched poly-Si layer (32);
depositing a poly-Si layer (35) on said ONO film (33);
etching all grown layers and deposited layers on said tunnel oxide (31) to form a rectangular stacked layer (30) with exposed regions of said tunnel oxide region (31)at two sides thereof;
ion-implanting a deep p-type region (27) at one side of said rectangular stacked layer (30) and in said N-well (24); and
ion-implanting a plurality of n-type regions (25,28) in said N-well (24) and at two sides of said rectangular stacked layer (30);
**characterized in that**
ion-implanting said N-well (24) in a deep P-well (22);
ion-implanting said deep P-well (22) in an N-substrate (20); and
performing oxidation to form a smiling effect oxide (312) between said rectangular stacked layer (30) and the surface of said N-well (24).

2. The fabricating method of claim 1 **characterized in that** said deep p-type region (27) is connected to one side of said shallow p-type region (26), and the implanted depth of said deep p-type region (27) is larger than that of said shallow p-type region (26).

3. The fabricating method of claim 1 **characterized in that** one of said n-type regions (25,28) is disposed in said deep p-type region (27).

4. The fabricating method of claim 1 **characterized in that** the fabricating method further comprises the following steps:
depositing a poly-Si layer (37) to cover said rectangular stacked layer (30) and two sides thereof;
etching said poly-Si layer (37) disposed at one side of said rectangular stacked layer (30) to form a contact hole (38) so as to expose said N-well (24) having said deep p-type region (27) and said n-type region (25) thereon; and
providing a metal contact (39) in said etched contact hole (38) of said poly-Si layer (37) to join said N-well (24) having said deep p-type region (27) and said n-type region (25) thereon.

5. The fabricating method of claim 1 **characterized in that** said p-type semiconductors and said n-type semiconductors in each step can interchange each other, e.g., an npn structure can be replaced with a pnp structure.

6. A structure of a low-voltage channel write/erase flash memory cell comprising:
an N-well (24) formed on a deep P-well (22), a deep p-type region (27) and a shallow p-type region (26) being ion-implanted at predetermined positions in said N-well (24); and
a stacked gate (30) disposed above said N-well (24) ;
**characterized in that**
an N-substrate (20); and
said deep P-well (22) formed on said N-substrate (20).

7. The structure of claim 6 **characterized in that** an oxide (31) is further disposed between said N-well (24) and said stacked gate (30).

8. The structure of claim 7 **characterized in that** a smiling effect pattern is etched out between said stacked gate (30) and said oxide (31).

9. The structure of claim 6 **characterized in that** an n-type region (25) is further ion-implanted in said deep p-type region (27) in said N-well (24) to be used as a drain.

10. The structure of claim 6 **characterized in that** the implanted depth of said deep p-type region (27) in said N-well (24) is larger than that of said shallow p-type region (26) in said N-well (24).

11. The structure of claim 6 **characterized in that** said deep p-type region (27) in said N-well (24) is connected to one end of said shallow p-type region (26) .

12. The structure of claim 6 **characterized in that** an n-type region (28) is further disposed at the other side of said shallow p-type region (26) in said N-well (24) to be used as a source.

13. The structure of claim 6 **characterized in that** said n-type region (25) implanted in said deep p-type region (27) is connected to said deep p-type region (27) via an electrical short circuit.

14. The structure of claim 13 **characterized in that** said electrical short circuit is formed by using a metal contact (29) to penetrate a junction of said n-type region (25) in said deep p-type region (27) and said deep p-type region (27).

15. The structure of claim 13 **characterized in that** said electrical short circuit is formed by using a metal contact to connect said exposed n-type region in said deep p-type region with said deep p-type region.

16. The structure of claim 6 **characterized in that** said n-type semiconductors and said p-type semiconductors can interchange each other, e.g., an npn structure can be replaced with a pnp structure.

17. A channel write/erase flash memory cell comprising:
a semiconductor wafer (20);
a first well (24) of first conductivity type formed in said semiconductor wafer (20);
a drain terminal (25) formed in a first area of said first well (24), wherein said drain terminal (25) comprises a first doped region (27) of second conductivity type and a second doped region (25) of first conductivity type within said first doped region (27), and wherein said second doped region (25) is electrically short-circuited with said first doped region (27);
a source terminal (28) formed in a second area of said first well (24) not overlapped with said first area; and
a stacked gate (30) formed on said first well (24) between said drain terminal (25) and said source terminal (28), said stacked gate (30) having a floating gate (32) above said first well (24) and a control gate (35) above said floating gate (32);
**characterized in that**
a second well (22) of second conductivity type formed beneath said first well (24).

18. The channel write/erase flash memory of claim 17 **characterized in that** when erasing said channel write/erase flash memory cell said drain (25) is floating, a well voltage is applied to said second well (22) and a source line voltage is applied to said source terminal (28), and wherein said well voltage is substantially equal to said source line voltage thereby avoiding a forward bias across a P-N junction between said second well (22) and said substrate (20).

19. The channel write/erase flash memory of claim 17 **characterized in that** said first conductivity type is N type and said second conductivity type is P type.

20. The channel write/erase flash memory of claim 17 **characterized in that** said source terminal (28) is a third doped region of first conductivity type.

21. The channel write/erase flash memory of claim 17 **characterized in that** said electrical short-circuit is formed by using a metal (29) that penetrates a junction between said first doped region (27) and said second doped region (25).

22. The channel write/erase flash memory of claim 17 **characterized in that** the channel write/erase flash memory further comprises a layer of a smiling effect oxide (312) disposed between said stacked gate (30) and said first well (24), wherein said layer of smiling effect oxide (312) has a larger thickness near an edge of said stacked gate (30) and a smaller thickness near a center of said stacked gate (30).
